# FASCICULE DE BREVET EUROPEEN

(11) **EP 3 672 383 B1**
(45) Date de publication et mention de la délivrance du brevet: **03.08.2022**
(21) Numéro de dépôt: 19213493.0
(22) Date de dépôt: 04.12.2019
(51) Int. Cl.: H05K 7/20

(54) **ENSEMBLE COMPRENANT UN DISPOSITIF ELECTRIQUE, UN ORGANE DE PLAQUAGE ET UNE PIECE DE MAINTIEN DE L'ORGANE DE PLAQUAGE**
EINHEIT, DIE EINE ELEKTRISCHE VORRICHTUNG, EIN PLATTIERORGAN UND EIN HALTEELEMENT DES PLATTIERORGANS UMFASST
ASSEMBLY COMPRISING AN ELECTRICAL DEVICE, A CLADDING MEMBER AND A PART FOR MAINTAINING THE CLADDING MEMBER

(30) Priorité: 21.12.2018 FR 1873808
(43) Date de publication de la demande: 24.06.2020
(73) Titulaire: Valeo Siemens eAutomotive France SAS, 95800 Cergy (FR)
(72) Inventeur: LEGENDRE, Alexandre, 95280 Jouy-le-Moutier (FR); POUILLY, Aurélien, 78300 Poissy (FR)

(56) Documents cités:
- EP-A2- 2 172 971
- WO-A1-2014/033382
- DE-B3-102013 109 532
- JP-A- 2000 223 630

## Description

### DOMAINE TECHNIQUE ET OBJET DE L'INVENTION

La présente invention concerne un ensemble comprenant un dispositif électrique, un organe de plaquage et une pièce de maintien de l'organe de plaquage. L'invention concerne également un équipement électrique comprenant un tel ensemble. Un tel équipement électrique peut être un onduleur, un convertisseur de tension ou un chargeur électrique de batterie, notamment configurés pour être embarqués dans un véhicule automobile électrique ou hybride.

### ÉTAT DE LA TECHNIQUE

Dans des applications de véhicule électrique ou hybride, les tensions électriques peuvent être élevées, par exemple comprises entre 200V et 800V. La génération de chaleur par effet joule peut alors devenir importante au risque d'endommager les équipements électriques du véhicule.

Afin d'éviter toute dégradation par la chaleur, un équipement électrique comprend généralement un système de refroidissement. Il est connu d'utiliser un organe de plaquage pour plaquer un dispositif électrique de l'équipement électrique contre une surface du système de refroidissement pour améliorer le refroidissement du dispositif électrique. Le document EP 2172971 A2 décrit un exemple de tel dispositif électrique comprenant un organe de placage pour plaquer un dispositif électrique de l'équipement électrique contre une surface du système de refroidissement.

Dans un onduleur embarqué dans un véhicule électrique ou hybride, on connaît un dispositif électrique, tel qu'un bloc capacitif. Le bloc capacitif comprend un ou plusieurs condensateurs connectés par un conducteur positif et un conducteur négatif. Typiquement, le bloc capacitif est rapporté sur un châssis de l'onduleur pour être plaqué contre le système de refroidissement de l'onduleur. Sur la face du bloc capacitif qui est opposée au système de refroidissement, un organe de plaquage appuie sur le bloc capacitif pour le plaquer contre le système de refroidissement. Généralement, l'organe de plaquage est d'abord monté sur une première partie du châssis, le bloc capacitif est monté sur une deuxième partie du châssis qui comprend le système de refroidissement. Puis les deux parties du châssis sont assemblées de sorte que l'organe de plaquage vient contre le bloc capacitif pour le plaquer contre le système de refroidissement.

Cependant, il y a un risque de désalignement entre l'organe de plaquage et le bloc capacitif, ce qui peut diminuer l'efficacité du plaquage du bloc capacitif. On peut utiliser des pions de guidage entre l'organe de plaquage et la première partie du châssis d'une part, entre le bloc capacitif et la deuxième partie du châssis d'autre part, et des pions de guidage entre la première partie du châssis et la deuxième partie du châssis. Mais cette solution peut être complexe à réaliser, car l'onduleur comprend plusieurs autres dispositifs électriques, chacun ayant ses propres contraintes de positionnement. L'ensemble des alignements à réaliser forme une contrainte sur la fabrication de l'onduleur, et plus généralement d'un équipement électrique.

Il est donc recherché un moyen pour faciliter l'alignement de l'organe de plaquage avec le dispositif électrique qu'il plaque au sein d'un équipement électrique.

### PRÉSENTATION GÉNÉRALE DE L'INVENTION

A cet effet, l'invention concerne un ensemble comportant :
- au moins un dispositif électrique comprenant une première face destinée à être plaquée contre une surface,
- au moins un organe de plaquage positionné sur une deuxième face du dispositif électrique opposée à la première face, ledit organe de plaquage étant destiné à être compressé et à participer au plaquage dudit dispositif électrique sur ladite surface,
- au moins une pièce de maintien qui maintient ledit organe de plaquage sur la deuxième face dudit dispositif électrique en étant fixée autour de l'organe de plaquage sur une portion périphérique du dispositif électrique.

Grace à la pièce de maintien, l'organe de plaquage est intégré sur une face du dispositif électrique. L'organe de plaquage est donc assemblé avec le dispositif électrique avant son montage sur un châssis d'un équipement électrique. Ainsi, on évite les problèmes de désalignement lors du montage du dispositif électrique dans le châssis de l'équipement électrique. L'organe de plaquage est donc maintenu en place sur le dispositif électronique lors d'une manipulation de l'ensemble. Ainsi, par exemple, la pièce de maintien permet de maintenir l'organe de plaquage entre un lieu où est assemblé l'ensemble et un autre lieu où l'ensemble est monté dans l'équipement électrique.

Selon un mode de réalisation, le bord de la pièce de maintien vient contre la périphérie du dispositif électrique de manière à enfermer l'organe de plaquage entre la pièce de maintien et le dispositif électrique. En particulier, la pièce de maintien est dédiée uniquement au dispositif électrique et participe seulement au maintien de l'organe de plaquage sur le dispositif électrique.

Selon une variante, la pièce de maintien comprend une paroi formant un fond et des parois latérales s'étendant dudit fond, ledit fond et lesdites parois latérales comprenant le bord de la pièce de maintien. Ainsi, le fond de la pièce de maintien protège l'organe de plaquage lors du transport et/ou de l'assemblage de l'ensemble.

Selon un mode de réalisation, la pièce de maintien définit un espace interne entre le fond de la pièce de maintien et la deuxième face du dispositif électrique. L'organe de plaquage est maintenu dans cet espace interne, par une coopération de la pièce de maintien avec la portion périphérique du dispositif électrique.

Selon un mode de réalisation, l'organe de plaquage est dépourvu d'attaches et est maintenu contre le dispositif électrique uniquement par la pièce de maintien venant autour dudit organe de plaquage. L'attachement de la pièce de maintien autour de l'organe de plaquage évite des attaches sur l'organe de plaquage et permet donc une plus grande liberté dans la conception de cet organe de plaquage.

Selon un mode de réalisation, la pièce de maintien est configurée de manière à transmettre un premier effort à l'organe de plaquage lorsque le dispositif électrique est plaqué contre la surface par un appui par l'intermédiaire de la pièce de maintien et de la deuxième face. Dans un équipement électrique comprenant l'ensemble selon ce mode de réalisation, ce premier effort est par exemple obtenu par une mise en pression de l'ensemble entre une première partie d'un châssis de l'équipement électrique et une deuxième partie du châssis de l'équipement électrique. La première partie du châssis vient contre la première face du dispositif électrique et la deuxième partie du châssis vient contre la pièce de maintien. Par exemple, une fois monté dans l'équipement électrique, le dispositif électrique est plaqué sur une surface, qui forme notamment une surface d'un circuit de refroidissement. Cela permet d'assurer un contact constant entre le dispositif électrique et la surface du circuit de refroidissement. Notamment, la pièce de maintien se déplace ou se déforme afin de transmettre ce premier effort vers l'organe de plaquage.

Selon une variante, la pièce de maintien est configurée de sorte à exercer un deuxième effort, inférieur au premier effort, sur l'organe de plaquage de manière à le maintenir contre la deuxième face du dispositif électrique, lorsque la pièce de maintien est libre de toute contrainte extérieure s'exerçant sur la pièce de maintien vers la dite deuxième face du dispositif électrique. Par exemple, dans les phases de transport et/ou de manipulation de l'ensemble selon cette variante, avant montage dans un équipement électrique, ce deuxième effort exercé sur l'organe de plaquage permet de s'assurer que l'organe de plaquage ne bouge pas. Ce deuxième effort peut être comparativement léger, mais il est de préférence suffisant pour garder l'organe de plaquage en place.

Selon une variante particulière, la pièce de maintien comprend des attaches avec le dispositif électrique. Les attaches présentent un jeu de sorte qu'une position distale de la pièce de maintien est obtenue lorsque la pièce de maintien est libre de toute contrainte extérieure s'exerçant sur la pièce de maintien vers la dite deuxième face du dispositif électrique ; et une position proximale de la pièce de maintien est obtenue lorsque le dispositif électrique est plaqué contre la surface par un appui par l'intermédiaire de ladite pièce de maintien et de ladite deuxième face. Le jeu des attaches permet de s'assurer que la pièce de maintien est suffisamment mobile pour occuper la position distale ou la position proximale.

Selon un mode de réalisation, le dispositif électrique comprend au moins un conducteur électrique. Le conducteur électrique permet de connecter le dispositif électrique, notamment à un autre élément électrique. Le conducteur électrique s'étend au moins dans la deuxième face du dispositif électrique. La pièce de maintien comporte au moins un premier organe de fixation et le conducteur électrique comporte au moins un deuxième organe de fixation. Le deuxième organe de fixation coopère avec le premier organe de fixation de manière à maintenir la pièce de maintien sur le dispositif électrique. Autrement dit, le deuxième organe de fixation est intégré dans le conducteur électrique. Par conséquent, il n'est pas nécessaire de rapporter une pièce sur le dispositif électrique et la fabrication est facilitée. Par exemple, le deuxième organe de fixation est un œillet intégré au conducteur électrique. Par exemple, le premier organe de fixation comporte à son extrémité un crochet coopérant avec l'œillet.

Selon un mode de réalisation alternatif, le dispositif électrique peut comprendre un boîtier, dont une face du boitier s'étend au moins dans la deuxième face du dispositif électrique. La pièce de maintien comporte au moins un premier organe de fixation et le boitier comporte au moins un deuxième organe de fixation coopérant avec le premier organe de fixation de manière à maintenir la pièce de maintien sur le dispositif électrique. Le deuxième organe de fixation est intégré dans le boitier. Par conséquent, il n'est pas nécessaire de rapporter une pièce sur le dispositif électrique et la fabrication est facilitée. Par exemple, le deuxième organe de fixation est un œillet intégré au boitier. Par exemple, le premier organe de fixation comporte à son extrémité un crochet coopérant avec l'œillet.

Selon une variante particulière, le premier organe de fixation est sur un bord de la pièce de maintien et le deuxième organe de fixation est sur un bord de la deuxième face du dispositif électrique, ou le deuxième organe de fixation est autour de la deuxième face du dispositif électrique.

Selon un mode de réalisation, la pièce de maintien est en un matériau isolant électrique.

Selon une variante, l'organe de plaquage est conducteur électriquement et est directement en contact avec le conducteur électrique. La pièce de maintien est configurée pour isoler électriquement l'organe de plaquage sur son côté opposé à la deuxième face du dispositif électrique. La pièce de maintien permet d'isoler le dispositif électrique par rapport à un environnement extérieur du côté de l'organe de plaquage.

Selon un mode de réalisation, l'ensemble est destiné à être monté dans un équipement électrique. L'ensemble est destiné à être pris en compression entre une première partie d'un châssis de l'équipement électrique et une deuxième partie du châssis de l'équipement électrique par l'intermédiaire de l'organe de plaquage et de la deuxième face.

Selon une variante, l'ensemble est destiné à être pris en compression entre une première partie d'un châssis de l'équipement électrique et une deuxième partie du châssis de l'équipement électrique par l'intermédiaire de l'organe de plaquage, de la deuxième face, et du fond de la pièce de maintien.

Selon un mode de réalisation, le dispositif électrique est un bloc capacitif.

L'invention concerne en outre un équipement électrique comprenant un châssis comportant une première partie rapportée sur une deuxième partie, et un ensemble selon l'invention. L'ensemble est pris en compression entre la première partie du châssis et la deuxième partie du châssis par l'intermédiaire de l'organe de plaquage et de la deuxième face.

Selon une variante, l'ensemble est pris en compression entre la première partie du châssis et la deuxième partie du châssis par l'intermédiaire de l'organe de plaquage et de la deuxième face, et du fond de la pièce de maintien. La face du fond opposée à l'organe de plaquage vient donc contre une paroi de la deuxième partie du châssis.

Selon une variante, la première partie du châssis comprend un circuit de refroidissement.

### PRÉSENTATION DES FIGURES

L'invention sera mieux comprise et d'autres détails, caractéristiques et avantages de l'invention apparaîtront à la lecture de la description suivante faite à titre d'exemple non limitatif en référence aux figures annexées dans lesquelles :
Fig. 1 est une vue en perspective éclatée d'un équipement électrique comprenant un dispositif électrique et un organe de plaquage, selon un exemple de réalisation de l'invention ;
Fig. 2 est une vue en coupe d'un équipement électrique comprenant un dispositif électrique et un organe de plaquage, selon un exemple de réalisation de l'invention ;
Fig. 3 est une vue en perspective d'un dispositif électrique avec une pièce de maintien selon un exemple de réalisation de l'invention ;
Fig. 4 est une vue de dessus d'un organe de plaquage en une pièce unique, selon un exemple de réalisation de l'invention ;
Fig. 5 est une vue en perspective d'une pièce de maintien, selon un exemple de réalisation de l'invention ;
Fig. 6 est une vue en perspective d'une autre pièce de maintien, selon un exemple de réalisation de l'invention ;
Fig. 7 est une vue de détail d'un dispositif électrique assemblé avec un organe de plaquage, selon un exemple de réalisation de l'invention ;
Fig. 8 est une vue en perspective d'un dispositif électrique sans pièce de maintien selon un exemple de réalisation de l'invention ;
Fig. 9 est une vue en perspective d'un dispositif électrique comprenant un boiter, selon un exemple de réalisation de l'invention.

Il faut noter que les figures exposent un exemple selon l'invention de manière détaillée pour le mettre en œuvre, lesdites figures pouvant bien entendu servir à mieux définir l'invention le cas échéant.

### DESCRIPTION DETAILLEE DE L'INVENTION

Dans l'exemple représenté par les figures, le dispositif électrique est un bloc capacitif. Cependant, le dispositif électrique pourrait être par exemple un bloc inductif ou un bloc résistif, entre autres.

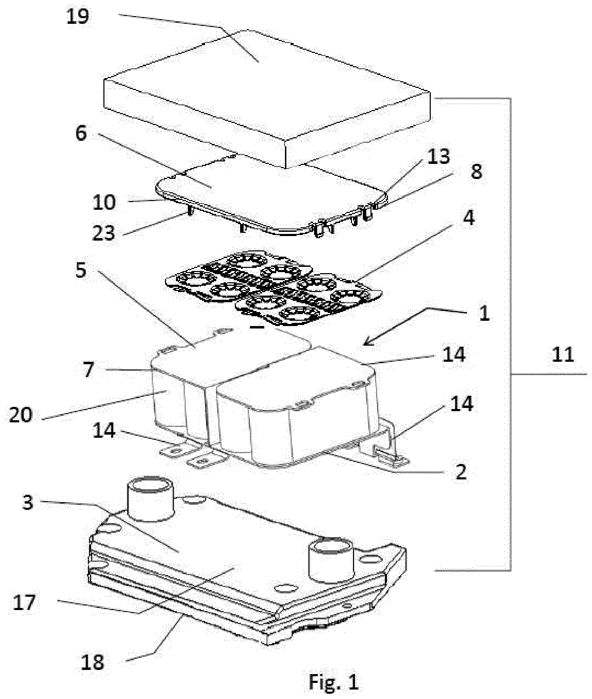

La figure 1 montre une partie d'un équipement électrique 11, tel qu'une partie d'un onduleur, en vue éclatée. Il est à noter que la présente invention s'applique également pour d'autres équipements électriques comprenant un circuit de refroidissement et dont un dispositif électrique doit être plaqué sur ce circuit de refroidissement. L'invention s'applique également par exemple dans le cas d'un chargeur électrique ou d'un convertisseur de tension continu-continu.

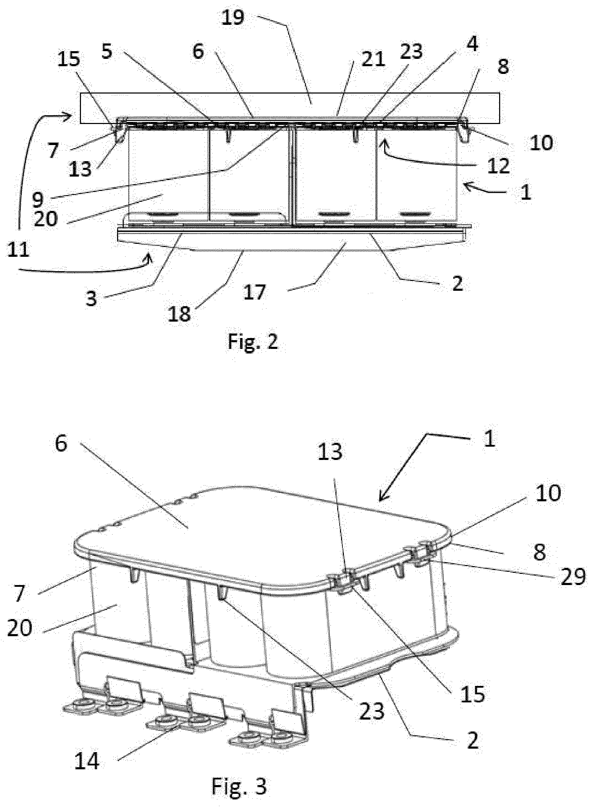

Comme représenté sur les figures 1 et 2, un organe de plaquage 4, ici en deux parties, est interposé entre le dispositif électrique 1, ici un bloc capacitif, et une pièce de maintien 6. L'ensemble est pris en compression par une première partie 18 du châssis et par une deuxième partie 19 du châssis. La première partie 18 du châssis comprend notamment un circuit de refroidissement 17 intégré. Seulement une partie du circuit de refroidissement 17 est représentée.

Le bloc capacitif 1 peut comprendre un ou plusieurs condensateurs 20. Ces condensateurs 20 sont par exemple des feuilles enroulées autour d'un axe, en forme de bobine. Dans l'exemple illustré à la figure 1 plusieurs condensateurs 20 sont regroupés ensemble, les axes d'enroulement étant parallèles. Des conducteurs électriques 14 sont fixés à chaque condensateur 20, notamment par soudure, afin de pouvoir connecter le bloc capacitif 1 électriquement. Les conducteurs électriques 14 viennent sur des bornes du condensateur, qui sont opposés suivant l'axe d'enroulement du condensateur. Les conducteurs électriques 14 et les condensateurs 20 constituent des faces 2, 5 du dispositif électrique 1. La génération de chaleur par les condensateurs 20 et les conducteurs électriques 14 peut devenir importante. Afin d'empêcher une surchauffe des différents composants, et donc de l'ensemble, une première face 2 du dispositif 1 est plaquée sur le circuit de refroidissement 17. Le circuit de refroidissement 17 comporte une surface 3, venant contre la face 2 du dispositif électrique 1. Le circuit de refroidissement 17 empêche une surchauffe du dispositif électrique 1 et de ses conducteurs électriques 14. Un contact constant, qui s'étend sur toute la face 2 du dispositif électrique est préférable. L'assemblage des deux parties 18, 19 du châssis applique un effort de compression du dispositif électrique 1 sur le circuit de refroidissement 17.

Afin de maintenir un contact permanent entre le dispositif électrique 1 et le circuit de refroidissement 17, on agence un organe de plaquage 4 sur une deuxième face 5 du dispositif électrique 1, opposée à la première face 2 du dispositif 1. L'organe de plaquage 4 presse alors le dispositif 1 contre le circuit de refroidissement 17.

Afin d'éviter un désalignement de l'organe de plaquage 4 et du dispositif électrique 1, une pièce de maintien 6 est agencée sur l'organe de plaquage 4. Par exemple, la pièce de maintien 6 comporte une paroi formant un fond 9 et des parois latérales 10. Les parois latérales 10 s'étendent du fond 9 et comprennent un bord 8 de la pièce de maintien 6. La pièce de maintien 6 englobe alors l'organe de plaquage 4 sur ses côtés et suivant une face. Sur sa face opposée, l'organe de plaquage 4 est posé sur le dispositif électrique 1. Le fond 9 et les parois latérales 10 permettent de recouvrir entièrement ledit organe de plaquage 4, et ainsi de le protéger de son environnement lors d'une manipulation de l'ensemble.

Afin de faciliter un montage aligné du dispositif électrique 1 avec l'organe de plaquage, l'organe de plaquage 4 est déjà pré assemblé avec le dispositif 1 grâce à la pièce de maintien 6, comme on peut le voir par exemple à la figure 3. De cette manière l'alignement de l'organe de plaquage 4 sur le dispositif électrique 1 est assuré. Le dispositif électrique 1 ne peut se déplacer dans des directions non-souhaitables, ni pendant l'assemblage finale, ni à l'utilisation.

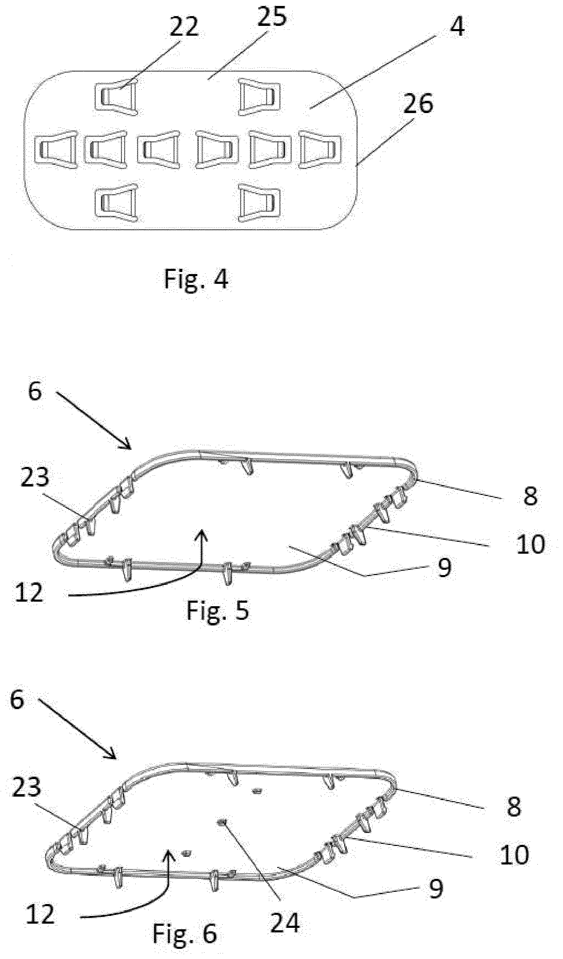

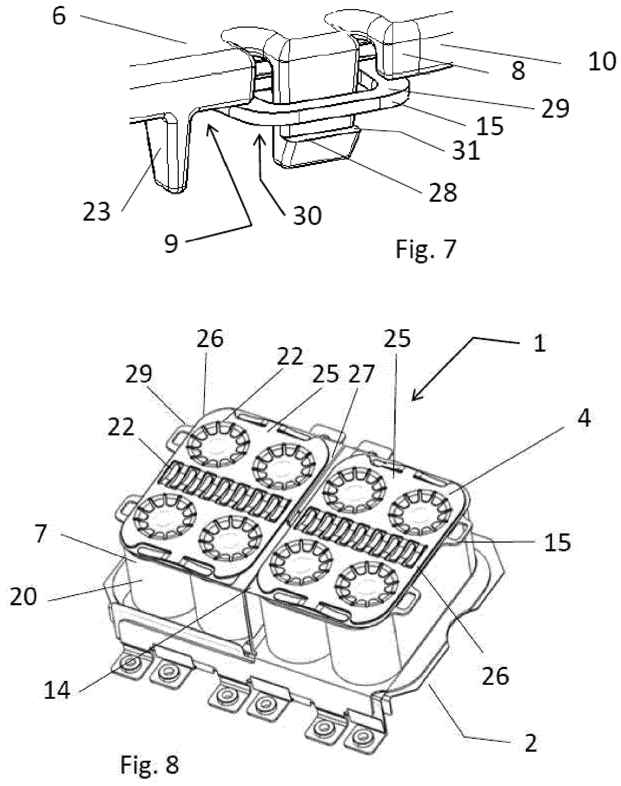

Comme on peut le voir aux figures 4 et 8, l'organe de plaquage 4 peut comprendre en outre des lames ressort 22. Les lames de ressort 22 s'étendent depuis la surface de l'organe de plaquage 4, en s'éloignant. Ces lames 22 génèrent l'effort exercé par l'organe de plaquage 4 sur la deuxième face 5 du dispositif électrique 1, qui permettra de presser le dispositif électrique 1 sur la surface 3 du circuit de refroidissement 17. La surface de l'organe de plaquage 4 n'est donc pas uniforme. Pour éviter des déformations non-souhaitables de l'organe de plaquage 4 une protection est préférable. Lors d'un transport du dispositif électrique 1 en vue d'un assemblage final, la pièce de maintien 6 maintient l'organe de plaquage 4 en place et le protège en même temps.

La pièce de maintien 6 doit donc répondre à plusieurs exigences techniques. Sur les figures 5, 6 et 7 une pièce de maintien 6 est illustrée, dans des vues d'ensemble et détaillée. La pièce de maintien 6 comprend une paroi de fond 9 et des parois latérales 10 s'étendant du fond 9. Le fond 9 et les parois latérales 10 comprenant le bord 8 de la pièce de maintien 6. Des avaloirs 23 s'étendent du fond 9, le long des parois latérales 10, et dépassent du bord 8. Les avaloirs 23 ont une forme essentiellement triangulaire, se diminuant en s'éloignant du fond. Les bouts des avaloirs 23 sont arrondis, afin d'éviter des accroches. Comme ils sont agencés tout autour de la pièce de maintien 6, un effet entonnoir permet un placement facile et ciblé lors de l'assemblage de la pièce de maintien 6 sur l'organe de plaquage 4 et le dispositif électrique 1. Les avaloirs 23 situés sur un côté de la pièce de maintien 6 coopèrent avec des avaloirs 23 situés sur le côté opposé de la pièce de maintien 6. Sachant qu'une répartition symétrique n'est pas nécessaire, au moins un avaloir 23 est préférable de chaque côté. Cependant deux avaloirs 23 par côté facilitent l'agencement. Les premières fixations 13, décrites plus loin, peuvent aussi faire office d'avaloir 23.

L'organe de plaquage 4 peut être composé d'une unique plaque ressort 25, comme illustré à la figure 4 ou il peut être composé de plusieurs plaques ressort 25 comme illustré par la figure 8 par exemple.

La pièce de maintien 6, illustrée par la figure 5 est prévue pour protéger et englober un organe de plaquage 4 d'une unique plaque ressort 25. L'organe de plaquage 4 s'étend dans ce cas sur toute la deuxième face 5 du dispositif électrique 1. Le fond 9 de la pièce de maintien 6 peut donc être lisse, le positionnement de l'organe de plaquage 4 se fait donc par le bord de la pièce de maintien 6, venant en correspondance avec un bord 26 de l'organe de plaquage 4. Entre l'organe de plaquage 4 et le dispositif électrique 1, une couche d'isolation peut être agencée. Cette couche d'isolation empêche un court-circuit entre l'organe de plaquage 4 et le dispositif électrique 1, notamment entre l'organe de plaquage 4 et les conducteurs électriques 14. La couche d'isolation peut être une feuille de matériau isolant.

La pièce de maintien 6, illustrée par la figure 6 est prévue pour protéger et englober un organe de plaquage 4 composé de plusieurs plaques ressort 25, en l'occurrence de deux plaques ressorts 25. Les plaques ressorts 25 couvrent dans ce cas ensemble la deuxième face 5 du dispositif électrique 1. Afin d'éviter un chevauchement éventuel des plaques ressorts 25 la pièce de maintien 6 comporte des excroissances 24, agencées au niveau de l'intervalle 27 entre les deux plaques ressorts 25. L'étendu des excroissances 24 doit correspondre au jeu des attaches 13, 15 décrit ultérieurement. Le positionnement de l'organe de plaquage 4 est alors assuré par le bord 8 de la pièce de maintien 6, coopérant avec le bord de l'organe de plaquage 26 et par les excroissances 24 coopérant avec l'intervalle 27 entre les deux plaques ressorts 25. L'ensemble peut être libre de couche isolante électrique entre l'organe de plaquage 4 et le dispositif électrique 1, notamment entre l'organe de plaquage 4 et les conducteurs électriques 14. Dans ce cas, la pièce de maintien 6 peut assurer une isolation électrique du dispositif électrique 1 avec l'environnement. La pièce de maintien 6 est alors d'une matière diélectrique.

Dans l'exemple présenté, la pièce de maintien 6 couvre entièrement l'organe de plaquage 4. Cependant il est aussi possible que la pièce de maintien 6 ne couvre l'organe de plaquage qu'en partie.

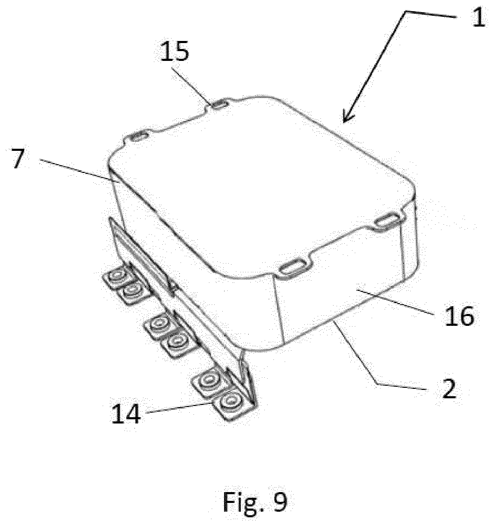

Comme illustré par la figure 3, des attaches 13, 15 servent à fixer la pièce de maintien 6 sur le dispositif électrique 1. Une attache comprend notamment un premier 13 et un deuxième 15 organe de fixation. Pour fixer la pièce de maintien 6 sur le dispositif électrique 1, le premier organe de fixation 13 se trouve sur un bord 8 de la pièce de maintien 6. Le deuxième organe de fixation 15 se trouve sur une portion périphérique 7 du dispositif électrique 1, notamment sur un bord de la deuxième face 5 du dispositif électrique 1 ou autour de la deuxième face 5 du dispositif électrique 1. Dans l'exemple de réalisation de l'invention illustré par les figures, le premier organe de fixation 13 est notamment une excroissance s'étendant du fond 9 de la pièce de maintien 6, le long des parois latérales 10, avec un talon en forme de crochet 28. Le deuxième organe de fixation 15 est notamment en forme d'œillet 29. À l'assemblage de la pièce de maintien 6 sur le dispositif électrique 1 le crochet 28 s'encliquette dans l'œillet 29. Les œillets 29 peuvent être intégrés, comme illustré par la figure 8, directement aux conducteurs électriques 14. Néanmoins, dans le cas, où le dispositif électrique 1 comporte un boîtier 16, comme illustré par la figure 9, les œillets peuvent être intégrés dans ce boitier 16. Notamment, l'œillet 29 est compris dans la deuxième face 5 du dispositif électrique 1. Cependant, l'œillet 29 pourrait être décalé par rapport à la deuxième face 5, sur une paroi latérale du dispositif électrique 1.

La figure 7 représente une attache 13, 15 en détail. On introduit le crochet 28 par un côté de l'œillet 29 de manière à fixer la pièce de maintien 6 sur le dispositif électrique 1. Le crochet 28 s'encliquette alors dans l'œillet 29. Le crochet 28 comporte une portion 31 qui vient en vis-à-vis d'une surface d'attache 30 de l'œillet 29. La portion 31 et la surface d'attache 30 de l'œillet 29 coopèrent pour permettre la tenue du crochet 28 dans l'œillet 29.

Lorsque le crochet est introduit dans l'œillet 29, une distance sépare l'œillet 29 du bord 8 ou du fond 9 de la pièce de maintien 6. Si bien que l'attache 13,15 présente un jeu. La pièce de maintien 6 peut donc être plus ou moins proche du dispositif électrique 1, en fonction de l'effort exercé sur elle. Par exemple, dans une première position, la pièce de maintien 6 est libre de toute contrainte venant de sa face extérieure. La pièce de maintien 6 subit une réaction de l'organe de plaquage 4, qui repousse la pièce de maintien 6. La portion 31 du crochet 28 vient en contact avec la surface d'attache 30 et maintient la pièce de maintien 6 ainsi que l'organe de plaquage 4 en position sur le dispositif électrique 1. La pièce de maintien 6 se trouve alors dans une position distale par rapport au dispositif électrique 1.

Lors du montage de l'ensemble, comportant le dispositif électrique 1, l'organe de plaquage 4 et la pièce de maintien 6, entre les deux parties 18, 19 du châssis, un effort sera exercé sur le dispositif électrique 1, afin de plaquer la première face 2 du dispositif électrique 1 sur la surface 3 du circuit de refroidissement 17. À cet effet, la deuxième partie 19 du châssis appuie sur la pièce de maintien 6, en particulier sur la face externe de la pièce de maintien 6 opposée à l'organe de plaquage 4. Le fond 9 de la pièce de maintien 6 se rapproche du dispositif électrique 1. Les avaloirs 23 sont notamment configurés pour coopérer avec la portion périphérique 7 du dispositif électrique 1 de manière à guider la pièce de maintien 6 vers la deuxième face 5 du dispositif électrique 1. L'organe de plaquage 4 est donc compressé, permettant un plaquage de la première face 2 du dispositif 1 sur la première partie 18 du châssis. La portion 31 du crochet 28 n'est plus en contact avec la surface d'attache 30. Une position proximale de la pièce de maintien 6 par rapport au dispositif électrique 1 est alors obtenue. La figure 7 illustre la position proximale de la pièce de maintien 6.

En particulier, dans sa position distale, la pièce de maintien 6 exerce quand même un effort sur l'organe de plaquage 4 afin d'éviter un déplacement latéral de l'organe de plaquage 4. Cet effort est alors faible par rapport à celui exercé sur l'organe de plaquage 4 lorsque l'ensemble est monté entre les deux parties 18, 19 de châssis.

## Revendications

1. Ensemble comportant :
- au moins un dispositif électrique (1) comprenant une première face (2) destinée à être plaquée contre une surface (3),
- au moins un organe de plaquage (4) positionné sur une deuxième face (5) du dispositif électrique (1) opposée à la première face (2), ledit organe de plaquage (4) étant destiné à être compressé et à participer au plaquage dudit dispositif électrique (1) sur ladite surface (3),
- au moins une pièce de maintien (6) qui maintient ledit organe de plaquage (4) sur la deuxième face (5) dudit dispositif électrique (1) en étant fixée autour de l'organe de plaquage (4) sur une portion périphérique (7) du dispositif électrique (1).

2. Ensemble selon la revendication 1, dans lequel un bord (8) de la pièce de maintien (6) vient contre la périphérie (7) du dispositif électrique (1) de manière à enfermer l'organe de plaquage (4) entre la pièce de maintien (6) et le dispositif électrique (1).

3. Ensemble selon la revendication 2, dans lequel la pièce de maintien (6) comprend une paroi formant un fond (9) et des parois latérales (10) s'étendant dudit fond (9), ledit fond (9) et lesdites parois latérales (10) comprenant le bord (8) de la pièce de maintien (6).

4. Ensemble selon l'une des revendications précédentes, dans lequel ladite pièce de maintien (6) est configurée de manière à transmettre un premier effort à l'organe de plaquage (4) lorsque ledit dispositif électrique (1) est plaqué contre ladite surface (3) par un appui par l'intermédiaire de ladite pièce de maintien (6) et de ladite deuxième face (5).

5. Ensemble selon la revendication précédente, dans lequel ladite pièce de maintien (6) est configurée de sorte à exercer un deuxième effort, inférieur au premier effort, sur l'organe de plaquage (4) de manière à le maintenir contre ladite deuxième face (5) du dispositif électrique (1), lorsque la pièce de maintien (6) est libre de toute contrainte extérieure s'exerçant sur la pièce de maintien (6) vers la dite deuxième face (5) du dispositif électrique.

6. Ensemble selon les revendications 4 et 5, dans lequel ladite pièce de maintien (6) comprend des attaches (13, 15) avec le dispositif électrique (1), lesdites attaches (13, 15) présentant un jeu de sorte que :
- une position distale de la pièce de maintien (6) est obtenue lorsque la pièce de maintien (6) est libre de toute contrainte extérieure s'exerçant sur la pièce de maintien (6) vers la dite deuxième face (5) du dispositif électrique (1), et
- une position proximale de la pièce de maintien (6) est obtenue lorsque ledit dispositif électrique (1) est plaqué contre ladite surface (3) par un appui par l'intermédiaire de ladite pièce de maintien (6) et de ladite deuxième face (5).

7. Ensemble selon l'une des revendications précédentes, dans lequel le dispositif électrique (1) comprend au moins un conducteur électrique (14) permettant de connecter le dispositif électrique (1), ledit conducteur électrique (14) s'étendant au moins dans ladite deuxième face (5) du dispositif électrique (1),
et dans lequel la pièce de maintien (6) comporte au moins un premier organe de fixation (13) et le conducteur électrique comporte au moins un deuxième organe de fixation (15) coopérant avec ledit premier organe de fixation (13) de manière à maintenir la pièce de maintien (6) sur le dispositif électrique (1).

8. Ensemble selon l'une des revendications 1 à 6, dans lequel le dispositif électrique (1) comprend un boîtier (16), une face dudit boitier (16) s'étendant au moins dans ladite deuxième face (5) du dispositif électrique (1),
et dans lequel la pièce de maintien (6) comporte au moins un premier organe de fixation (13) et ledit boitier (16) comporte au moins un deuxième organe de fixation (15) coopérant avec ledit premier organe de fixation (13) de manière à maintenir la pièce de maintien (6) sur le dispositif électrique (1).

9. Ensemble selon l'une des revendications précédentes, dans lequel la pièce de maintien (6) est en un matériau isolant électriquement.

10. Ensemble selon la revendication précédente et la revendication 7, dans lequel l'organe de plaquage (4) est conducteur électriquement et est directement en contact avec ledit conducteur électrique (14), et ladite pièce de maintien (6) est configurée pour isoler électriquement ledit organe de plaquage (4) sur son côté opposé à la deuxième face (5) du dispositif électrique (1).

11. Ensemble selon l'une des revendications précédentes, destiné à être monté dans un équipement électrique, l'ensemble étant destiné à être pris en compression entre une première partie d'un châssis de l'équipement électrique et une deuxième partie du châssis de l'équipement électrique par l'intermédiaire de l'organe de plaquage (4) et de la deuxième face (5).

12. Ensemble selon la revendication 11 et la revendication 3, dans lequel l'ensemble est destiné à être pris en compression entre une première partie d'un châssis de l'équipement électrique et une deuxième partie du châssis de l'équipement électrique par l'intermédiaire de l'organe de plaquage, de la deuxième face, et du fond (9) de la pièce de maintien (6).

13. Équipement électrique (11) comprenant :
- un châssis comportant une première partie (18) rapportée sur une deuxième partie (19), et
- un ensemble selon l'une des revendications précédentes,
dans lequel l'ensemble est pris en compression entre la première partie du châssis (18) et la deuxième partie du châssis (19) par l'intermédiaire de l'organe de plaquage (4) et de la deuxième face (5).

14. Équipement électrique (11) selon la revendication précédente, comprenant un ensemble selon la revendication 3, dans lequel l'ensemble est pris en compression entre la première partie du châssis et la deuxième partie du châssis par l'intermédiaire de l'organe de plaquage (4) et de la deuxième face (5), et du fond (9) de la pièce de maintien (1).

## Patentansprüche

1. Anordnung, umfassend:
- wenigstens eine elektrische Vorrichtung (1) mit einer ersten Seite (2), die dazu bestimmt ist, an eine Fläche (3) angedrückt zu sein,
- wenigstens ein Andrückelement (4), das auf einer zweiten Seite (5) der elektrischen Vorrichtung (1) positioniert ist, die der ersten Seite (2) gegenüberliegt, wobei das Andrückelement (4) dazu bestimmt ist, zusammengedrückt zu sein und am Andrücken der elektrischen Vorrichtung (1) an die Fläche (3) beteiligt zu sein,
- wenigstens ein Halteteil (6), das das Andrückelement (4) auf der zweiten Seite (5) der elektrischen Vorrichtung (1) hält, wobei es um das Andrückelement (4) auf einem Randbereich (7) der elektronischen Vorrichtung (1) befestigt ist.

2. Anordnung nach Anspruch 1, wobei eine Kante (8) des Halteteils (6) so am Rand (7) der elektrischen Vorrichtung (1) anliegt, dass sie das Andrückelement (4) zwischen dem Halteteil (6) und der elektrischen Vorrichtung (1) einschließt.

3. Anordnung nach Anspruch 2, wobei das Halteteil (6) eine Wand, die einen Boden (9) bildet, und Seitenwände (10) umfasst, die sich von dem Boden (9) erstrecken, wobei der Boden (9) und die Seitenwände (10) die Kante (8) des Halteteils (6) umfassen.

4. Anordnung nach einem der vorhergehenden Ansprüche, wobei das Halteteil (6) so ausgebildet ist, dass es eine erste Kraft auf das Andrückelement (4) überträgt, wenn die elektrische Vorrichtung (1) durch eine Auflage mittels des Halteteils (6) und der zweiten Seite (5) an die Fläche (3) angedrückt ist.

5. Anordnung nach dem vorhergehenden Anspruch, wobei das Halteteil (6) so ausgebildet ist, dass es eine zweite Kraft, die geringer als die erste Kraft ist, auf das Andrückelement (4) ausübt, so dass es gegen die zweite Fläche (5) der elektrischen Vorrichtung (1) gehalten wird, wenn das Halteteil (6) frei von jeglicher äußerer Spannung ist, die auf das Halteteil (6) in Richtung der zweiten Seite (5) der elektrischen Vorrichtung wirkt.

6. Anordnung nach den Ansprüchen 4 und 5, wobei das Halteteil (6) Befestigungen (13, 15) mit der elektrischen Vorrichtung (1) umfasst, wobei die Befestigungen (13, 15) ein Spiel aufweisen, so dass:
- eine distale Position des Halteteils (6) erhalten wird, wenn das Halteteil (6) frei von jeglicher äußerer Spannung ist, die auf das Halteteil (6) in Richtung der zweiten Seite (5) der elektrischen Vorrichtung (1) wirkt, und
- eine proximale Position des Halteteils (6) erhalten wird, wenn die elektrische Vorrichtung (1) durch eine Auflage mittels des Halteteils (6) und der zweiten Seite (5) an die Fläche (3) angedrückt ist.

7. Anordnung nach einem der vorhergehenden Ansprüche, wobei die elektrische Vorrichtung (1) wenigstens einen elektrischen Leiter (14) umfasst, mit dem die elektrische Vorrichtung (1) angeschlossen werden kann, wobei sich der elektrische Leiter (14) wenigstens in der zweiten Seite (5) der elektrischen Vorrichtung (1) erstreckt,
und wobei das Halteteil (6) wenigstens ein erstes Befestigungselement (13) aufweist und der elektrische Leiter wenigstens ein zweites Befestigungselement (15) aufweist, das mit dem ersten Befestigungselement (13) so zusammenwirkt, dass das Halteteil (6) auf der elektrischen Vorrichtung (1) gehalten wird.

8. Anordnung nach einem der Ansprüche 1 bis 6, wobei die elektrische Vorrichtung (1) ein Gehäuse (16) umfasst, wobei sich eine Seite des Gehäuses (16) wenigstens in der zweiten Seite (5) der elektrischen Vorrichtung (1) erstreckt,
und wobei das Halteteil (6) wenigstens ein erstes Befestigungselement (13) und das Gehäuse (16) wenigstens ein zweites Befestigungselement (15) aufweist, das mit dem ersten Befestigungselement (13) so zusammenwirkt, dass das Halteteil (6) auf der elektrischen Vorrichtung (1) gehalten wird.

9. Anordnung nach einem der vorhergehenden Ansprüche, wobei das Halteteil (6) aus einem elektrisch isolierenden Material ist.

10. Anordnung nach dem vorhergehenden Anspruch und Anspruch 7, wobei das Andrückelement (4) elektrisch leitfähig ist und mit dem elektrischen Leiter (14) direkt in Kontakt steht und das Halteteil (6) dazu ausgebildet ist, das Andrückelement (4) auf dessen Seite, die der zweiten Seite (5) der elektrischen Vorrichtung (1) gegenüberliegt, elektrisch zu isolieren.

11. Anordnung nach einem der vorhergehenden Ansprüche zum Einbau in eine elektrische Einrichtung, wobei die Anordnung dazu bestimmt ist, mittels des Andrückelements (4) und der zweiten Seite (5) zwischen einem ersten Abschnitt eines Grundträgers der elektrischen Einrichtung und einem zweiten Abschnitt des Grundträgers der elektrischen Einrichtung zusammengedrückt zu sein.

12. Anordnung nach Anspruch 11 und 3, wobei die Anordnung dazu bestimmt ist, mittels des Andrückelements, der zweiten Seite und des Bodens (9) des Halteteils (6) zwischen einem ersten Abschnitt eines Grundträgers der elektrischen Einrichtung und einem zweiten Abschnitt des Grundträgers der elektrischen Einrichtung zusammengedrückt zu sein.

13. Elektrische Einrichtung (11), umfassend:
- einen Grundträger, der einen ersten Abschnitt (18) aufweist, der auf einen zweiten Abschnitt (19) aufgesetzt ist, und
- eine Anordnung nach einem der vorhergehenden Ansprüche,
wobei die Anordnung zwischen dem ersten Abschnitt des Grundträgers (18) und dem zweiten Abschnitt des Grundträgers (19) mittels des Andrückelements (4) und der zweiten Seite (5) zusammengedrückt ist.

14. Elektrische Einrichtung (11) nach dem vorhergehenden Anspruch, umfassend eine Anordnung nach Anspruch 3, wobei die Anordnung mittels des Andrückelements (4) und der zweiten Seite (5) und des Bodens (9) des Halteteils (1) zwischen dem ersten Abschnitt des Grundträgers und dem zweiten Abschnitt des Grundträgers zusammengedrückt ist.

## Claims

1. Assembly comprising:
- at least one electrical device (1) comprising a first face (2) intended to be pressed against a surface (3),
- at least one pressing member (4) positioned on a second face (5) of the electrical device (1) opposite to the first face (2), said pressing member (4) being intended to be compressed and to participate in the pressing of said electrical device (1) on said surface (3),
- at least one retaining part (6) which retains said pressing member (4) on the second face (5) of said electrical device (1) by being fastened around the pressing member (4) on a peripheral portion (7) of the electrical device (1).

2. Assembly according to Claim 1, wherein an edge (8) of the retaining part (6) comes against the periphery (7) of the electrical device (1) so as to enclose the pressing member (4) between the retaining part (6) and the electrical device (1).

3. Assembly according to Claim 2, wherein the retaining part (6) comprises a wall forming a bottom (9) and lateral walls (10) extending from said bottom (9), said bottom (9) and said lateral walls (10) comprising the edge (8) of the retaining part (6).

4. Assembly according to one of the preceding claims, wherein said retaining part (6) is configured so as to transmit a first force to the pressing member (4) when said electrical device (1) is pressed against said surface (3) by a pressure via said retaining part (6) and said second face (5).

5. Assembly according to the preceding claim, wherein said retaining part (6) is configured so as to exert a second force, which is less than the first force, on the pressing member (4) so as to retain it against said second face (5) of the electrical device (1) when the retaining part (6) is free from any external stress exerted on the retaining part (6) towards said second face (5) of the electrical device.

6. Assembly according to Claims 4 and 5, wherein said retaining part (6) comprises attachments (13, 15) with the electrical device (1), said attachments (13, 15) having a play such that:
- a distal position of the retaining part (6) is obtained when the retaining part (6) is free from any external stress exerted on the retaining part (6) towards said second face (5) of the electrical device (1), and
- a proximal position of the retaining part (6) is obtained when said electrical device (1) is pressed against said surface (3) by a pressure via said retaining part (6) and second face (5).

7. Assembly according to one of the preceding claims, wherein the electrical device (1) comprises at least one electrical conductor (14) for connecting the electrical device (1), said electrical conductor (14) extending at least in said second face (5) of the electrical device (1),
and wherein the retaining part (6) comprises at least one first fastening member (13) and the electrical conductor comprises at least one second fastening member (15) cooperating with said first fastening member (13) so as to retain the retaining part (6) on the electrical device (1).

8. Assembly according to one of Claims 1 to 6, wherein the electrical device (1) comprises a housing (16), a face of said housing (16) extending at least in said second face (5) of the electrical device (1), and wherein the retaining part (6) comprises at least one first fastening member (13) and said housing (16) comprises at least one second fastening member (15) cooperating with said first fastening member (13) so as to retain the retaining part (6) on the electrical device (1).

9. Assembly according to one of the preceding claims, wherein the retaining part (6) is made of an electrically insulating material.

10. Assembly according to the preceding claim and Claim 7, wherein the pressing member (4) is electrically conductive and is directly in contact with said electrical conductor (14), and said retaining part (6) is configured to electrically insulate said pressing member (4) on its side opposite to the second face (5) of the electrical device (1).

11. Assembly according to one of the preceding claims, intended to be mounted in an electrical equipment item, the assembly being intended to be compressed between a first part of a chassis of the electrical equipment item and a second part of the chassis of the electrical equipment item via the pressing member (4) and the second face (5).

12. Assembly according to Claim 11 and Claim 3, wherein the assembly is intended to be compressed between a first part of a chassis of the electrical equipment item and a second part of the chassis of the electrical equipment item via the pressing member, the second face and the bottom (9) of the retaining part (6).

13. Electrical equipment item (11) comprising:
- a chassis comprising a first part (18) attached to a second part (19), and
- an assembly according to one of the preceding claims,
wherein the assembly is compressed between the first part of the chassis (18) and the second part of the chassis (19) via the pressing member (4) and the second face (5).

14. Electrical equipment item (11) according to the preceding claim, comprising an assembly according to Claim 3, wherein the assembly is compressed between the first part of the chassis and the second part of the chassis via the pressing member (4) and the second face (5) and the bottom (9) of the retaining part (1).
